# EUROPEAN PATENT APPLICATION

(11) **EP 1 729 341 A2**
(43) Date of publication of application: **06.12.2006**
(21) Application number: 06252853.4
(22) Date of filing: 01.06.2006
(51) Int. Cl.: H01L 23/31, H01L 23/433

(54) **Semiconductor IC and its manufacturing method, and module with embedded semiconductor IC and its manufacturing method**

(30) Priority: 01.06.2005 JP 2005161414
(71) Applicant: TDK Corporation, Tokyo 103-8272 (JP)
(72) Inventor: Kawabata, Kenichi, Tokyo 103-8272 (JP); Abe, Hisayuki, Tokyo 103-8272 (JP)
(74) Representative: Mounteney, Simon James

(57) **Abstract**

A semiconductor IC includes a semiconductor IC main body having a predetermined circuit formed on a main surface, a metal layer selectively provided on substantially the whole back surface of the semiconductor IC main body excluding the periphery. According to the present invention, the metal layer provided on the semiconductor IC main body can dissipate heat at a high level. Because the metal layer is selectively provided, even when the semiconductor IC main body is thinned by polishing, warpage does not occur easily in a wafer state. The metal layer is selectively provided at the center of the back surface of the semiconductor IC. Therefore, a laminate of a semiconductor wafer and a thick metal does not need to be diced. As a result, chipping on the disconnected surface can be prevented effectively.

## Description

### TECHNICAL FIELD

The present invention relates to a semiconductor integrated circuit (hereinafter, "semiconductor IC") and a method of manufacturing the same. Particularly, the invention relates to a semiconductor IC that can be suitably embedded in a circuit board, and a method of manufacturing this semiconductor IC. The present invention also relates to a module with embedded semiconductor IC, and a method of manufacturing the same. Particularly, the invention relates to a module with embedded semiconductor IC having excellent heat dissipation, and a method of manufacturing this module with embedded semiconductor IC.

### BACKGROUND OF THE INVENTION

In recent years, in order to meet the requirement for a compact and thin module with embedded semiconductor IC, there have been many proposals of mounting a semiconductor IC in a bare chip state on a circuit board. However, when a semiconductor IC is mounted on the surface of the circuit board, a part of the surface of the circuit board is occupied by the semiconductor IC. Accordingly, utilization efficiency of the circuit board decreases. Furthermore, because the semiconductor IC is mounted on the circuit board, it has been difficult to decrease the total thickness of the module.

In order to solve the above problems, it is proposed that a method of configuring a module with embedded semiconductor IC by forming a cavity on the circuit board. A semiconductor IC in a bare chip state is then embedded in the cavity. See Japanese Patent Laid Open No. H9-321408.

However, according to the method described in Japanese Patent Laid Open No. H9-321408, a large part of the embedded semiconductor IC is covered with a resin. Therefore, it is difficult to efficiently dissipate heat generated by the operation of the semiconductor IC. Consequently, it has not been realistic to embed a semiconductor IC having a high operation frequency and large heat generation such as a CPU (central processing unit) and a DSP (digital signal processor).

A semiconductor IC with a metal plate adhered to the back surface is proposed so as to improve heat dissipation from a semiconductor IC, as described in Japanese Patent Laid Open No. 2003-174116. The semiconductor IC described in Japanese Patent Laid Open No. 2003-174116 is manufactured as follows.

A metal plate is adhered to the back surface of a wafer, via a welding sheet. Thereafter, the wafer is divided into individual semiconductor ICs, by dicing. However, the semiconductor wafer has a rigid and fragile characteristic, and the metal plate has high extension characteristic. Therefore, it is practically very difficult to dice without problem a laminate made of different kinds of materials having greatly different physical characteristics. Specifically, when the laminate made of different kinds of materials is diced, very severe chipping or extension occurs on the disconnected surface, and the semiconductor ICs cannot be practically used.

A module with embedded semiconductor IC that has a semiconductor IC built in the circuit board, applied by the applicant of the present invention, is also described in Japanese Patent Laid Open No. 2005-64470. According to the module with embedded semiconductor IC described in Japanese Patent Laid Open No. 2005-64470, a large part of the embedded semiconductor IC is covered with a resin. Therefore, heat dissipation is not satisfactory.

According to the module with embedded semiconductor IC described in Japanese Patent Laid Open No. 2005-64470, a semiconductor IC to be built in is thinned in advance, thereby decreasing a total thickness of the module with embedded semiconductor IC. However, in the case of decreasing the thickness of the semiconductor IC, when a metal plate is adhered in a wafer state to improve heat dissipation as described in Japanese Patent Laid Open No. 2003-174116, large warpage occurs in the semiconductor wafer, due to a difference between a thermal expansion coefficient of the semiconductor wafer and a thermal expansion coefficient of the metal plate. As a result, easiness of handling and productivity decrease. When a metal plate is adhered to the whole surface of a semiconductor wafer, dicing becomes considerably difficult, as described above.

### SUMMARY OF THE INVENTION

The present invention has been achieved to solve the above problems. It is therefore an object of the present invention to provide a semiconductor IC that can obtain high heat dissipation even when the semiconductor IC is embedded in a circuit board and that can be manufactured easily using a process of a printed circuit, and provide a method of manufacturing this semiconductor IC.

It is another object of the present invention to provide a module with embedded semiconductor IC that has a semiconductor IC having above characteristics built in a module, and provide a method of manufacturing the module with embedded semiconductor IC.

The semiconductor IC according to the present invention includes a semiconductor IC main body on the main surface of which a predetermined circuit is formed, and a metal layer selectively provided at the center of the back surface of the semiconductor IC main body.

According to the present invention, the semiconductor IC can have high heat dissipation, using a metal layer provided at the center of the back surface of the semiconductor IC main body. Because the metal layer is selectively provided, warpage does not occur easily in the wafer state, even when the semiconductor IC main body is thinned by polishing or the like. Because a position at which the metal layer is selectively provided is the center of the back surface of the semiconductor IC main body, it is not necessary to dice the laminate of the semiconductor wafer and the thick metal. As a result, chipping of the disconnected surface can be prevented effectively.

Preferably, the metal layer is provided on substantially the whole back surface of the semiconductor IC main body except the periphery of the back surface. When the metal layer is provided on substantially the whole back surface of the semiconductor IC main body, higher heat dissipation can be obtained.

Preferably, the semiconductor IC according to the present invention further includes an under-barrier metal layer provided between at least the metal layer and the back surface of the semiconductor IC main body. In the presence of the under-barrier metal layer, close adhesion between the metal layer and the semiconductor IC main body can be increased.

Preferably, the semiconductor IC according to the present invention further includes a rust preventing film that covers the bottom surface and the side surface of the metal layer. When this rust preventing film is provided, the occurrence of oxidation and corrosion can be prevented, even when a material that can easily generate oxidation or corrosion is used as a material of the metal layer.

When a semiconductor IC is embedded in a resin layer, close adhesion between the semiconductor IC main body and the resin layer can be increased. Preferably, the rust preventing film is selectively provided in a region of the back surface of the semiconductor IC main body except the periphery of the back surface. According to this arrangement, chipping of the disconnected surface can be prevented at the time of dicing the semiconductor wafer, because the rust preventing film is not present in the dicing region.

A method of manufacturing a semiconductor IC according to the present invention includes: a first step for selectively forming a metal layer on the back surface of a semiconductor wafer on the main surface of which a predetermined circuit is formed; and a second step for disconnecting the semiconductor wafer along a region in which the metal layer is not formed.

According to the present invention, the metal layer is selectively provided. Therefore, warpage does not occur easily in the wafer state, even when the semiconductor IC main body is thinned by polishing or the like. Furthermore, chipping of the disconnected surface can be prevented effectively at the dicing time.

Preferably, the first process includes: a step for forming an under-barrier metal layer on substantially the whole back surface of the semiconductor wafer; and a step for selectively forming the metal layer on the under-barrier metal layer, by plating while covering a part of the under-barrier metal layer with a resist. According to this method, close adhesion between the metal layer and the semiconductor IC main body can be increased. Furthermore, the metal layer can be selectively formed easily.

Preferably, the first process further includes:
a step for removing the resist after selectively forming the metal layer; and a step for removing the under-barrier metal layer exposed by removing the resist. According to this arrangement, chipping of the disconnected surface can be prevented at the time of dicing the semiconductor wafer, because the rust preventing film is not present in the dicing region.

Preferably, the method of manufacturing a semiconductor IC includes a step for thinning the semiconductor wafer before performing the first process. According to this method, when the semiconductor IC is embedded in the resin layer, the total of the module with embedded semiconductor IC can be thinned.

Preferably, the method of manufacturing a semiconductor IC further includes a step for forming a rust preventing film that covers the bottom surface and the side surface of the metal layer after performing the first step and before performing the second step. When this rust preventing film is provided, the occurrence of oxidation and corrosion can be prevented, even when a material that can easily generate oxidation or corrosion is used as a material of the metal layer.

Preferably, the rust preventing film is selectively formed on substantially the whole back surface of the semiconductor wafer, except at least a part of the region of the back surface not covered with the metal layer. According to this arrangement, chipping of the disconnected surface can be prevented at the time of dicing the semiconductor wafer, because the rust preventing film is not present in the dicing region.

Preferably, the method of manufacturing a semiconductor IC further includes a step for roughening the surface of the metal layer. According to this method, when a semiconductor IC is embedded in a resin layer, close adhesion between the semiconductor IC and the resin layer can be further increased.

A module with embedded semiconductor IC according to the present invention includes the semiconductor IC and a resin layer into which the semiconductor IC is embedded. According to the semiconductor IC, high heat dissipation can be obtained using the metal layer provided at the center of the back surface of the semiconductor IC main body. Therefore, it is possible to provide a thin module with embedded semiconductor IC that has a semiconductor IC built in to generate a large amount of heat by high-speed switching.

Preferably, the bottom surface of the resin layer forms substantially the same plane as the bottom surface of the metal layer provided on the semiconductor IC main body. With this arrangement, substantially the whole surface of the metal layer becomes in an exposed state. Therefore, remarkably high heat dissipation can be obtained.

A method of manufacturing a module with embedded semiconductor IC according to the present invention includes: a first step for embedding the semiconductor IC in a resin layer; and a second step for exposing at least a part of the surface of the metal layer provided on the semiconductor IC main body. According to the present invention, the metal layer of the semiconductor IC embedded in the resin layer is exposed. Therefore, a module with embedded semiconductor IC having high heat dissipation can be provided.

The second process can be performed by exposing substantially the whole bottom surface of the metal layer by polishing the bottom surface of the resin layer, or can be performed by exposing at least a part of the bottom surface of the metal layer by forming via holes on the bottom surface of the resin layer. When via holes are formed on the bottom surface of the resin layer, it is preferable that the method of manufacturing a module with embedded semiconductor IC further includes a third step for embedding the via holes with a material having higher thermal conductivity than that of the resin layer.

According to this method, heat can be efficiently dissipated from the surface of the metal layer exposed in the second process, via the embedded material. As a material having high thermal conductivity, preferably a material including a filler in conductive or insulating paste can be used, in addition to metal.

### BRIEF DESCRIPTION OF THE DRAWINGS

The above and other objects, features and advantages of this invention will become more apparent by reference to the following detailed description of the invention taken in conjunction with the accompanying drawings, wherein:
FIG. 1 is a schematic cross-sectional view of a configuration of a semiconductor IC according to a preferred embodiment of the present invention;
FIG. 2 is a flowchart showing a method of manufacturing the semiconductor IC shown in FIG. 1;
FIG. 3 is a diagram showing a part of the manufacturing process of the semiconductor IC shown in FIG. 1 (formation of an under-barrier metal layer);
FIG. 4 is a diagram showing a part of the manufacturing process of the semiconductor IC shown in FIG. 1 (formation of a resist);
FIG. 5 is a diagram showing a part of the manufacturing process of the semiconductor IC shown in FIG. 1 (patterning a resist);
FIG. 6 is a partial plan view showing a patterned resist;
FIG. 7 is a diagram showing a part of the manufacturing process of the semiconductor IC shown in FIG. 1 (patterning a metal layer);
FIG. 8 is a diagram showing a part of the manufacturing process of the semiconductor IC shown in FIG. 1 (removing a resist);
FIG. 9 is a diagram showing a part of the manufacturing process of the semiconductor IC shown in FIG. 1 (removing an under-barrier metal layer);
FIG. 10 is an explanatory diagram of a method of performing dicing without removing an under-barrier metal layer;
FIG. 11 is a schematic cross-sectional view of a configuration of a semiconductor IC according to another preferred embodiment of the present invention;
FIG. 12 is an explanatory diagram of a method of sputtering using a metal mask;
FIG. 13 is a diagram showing a configuration obtained by sputtering using a metal mask;
FIG. 14 a schematic cross-sectional view of a configuration of a module with embedded semiconductor IC according to a preferred embodiment of the present invention;
FIG. 15 is a diagram showing a part of the manufacturing process of the module with embedded semiconductor IC shown in FIG. 14 (pressing by prepregs);
FIG. 16 is a diagram showing a part of the manufacturing process of the module with embedded semiconductor IC shown in FIG. 14 (formation of a resin layer);
FIG. 17 is a diagram showing a part of the manufacturing process of the module with embedded semiconductor IC shown in FIG. 14 (polishing a bottom surface of the resin layer);
FIG. 18 is a diagram showing a part of the manufacturing process of the module with embedded semiconductor IC shown in FIG. 14 (polishing an upper surface of the resin layer);
FIG. 19 is a diagram showing a part of the manufacturing process of the module with embedded semiconductor IC shown in FIG. 14 (formation of an internal conductive layer);
FIG. 20 shows a method of exposing a part of a metal layer by forming via holes;
FIG. 21 shows a state that an embedding material is embedded in the via holes;
FIG. 22 shows a method of exposing a part of a stud bump by forming via holes;
FIG. 23 shows a method of polishing a resin layer after forming an internal conductive pattern and a resin layer;
FIG. 24 shows a semiconductor IC that is positioned and fixed on a transfer substrate;
FIG. 25 shows a state before pressing a transfer substrate and a prepreg;
FIG. 26 shows a state that the transfer substrate is separated after the transfer substrate and the prepreg are pressed;
FIG. 27 shows a state that the transfer substrate is polished after the transfer substrate and the prepreg are pressed; and
FIG. 28 shows a state that the transfer substrate is laser-via processed after the transfer substrate and the prepreg are pressed.

### DETAILED DESCRIPTION OF THE EMBODIMENTS

Preferred embodiments of the present invention will now be explained in detail with reference to the drawings.

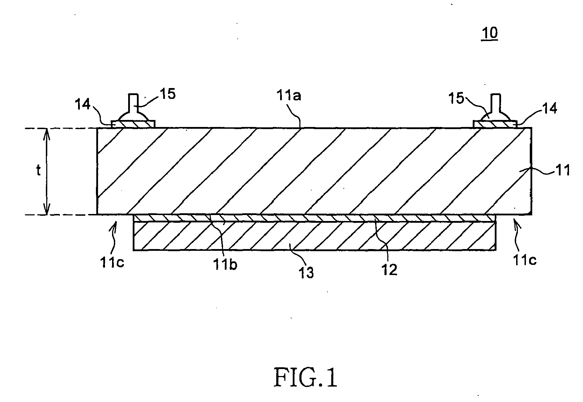

FIG. 1 is a schematic cross-sectional view of a configuration of a semiconductor IC 10 according to a preferred embodiment of the present invention.

As shown in FIG. 1, the semiconductor IC 10 according to the present embodiment includes: a semiconductor IC main body 11 on a main surface 11a of which a predetermined circuit (not shown) is formed; an under-barrier metal layer 12 provided at the center of a back surface 11b of the semiconductor IC main body 11; and a metal layer 13 provided on the under-barrier metal layer 12.

While any types of IC can be used as the semiconductor IC 10, a digital IC having a very high operation frequency such as a CPU and a DSP can be selectively used. This kind of semiconductor IC generates a large amount of heat by high-speed switching. As described later, the semiconductor IC 10 according to the present embodiment can dissipate heat to a motherboard remarkably efficiently, even when the semiconductor IC 10 is embedded in the multilayer substrate. Therefore, a digital IC that generates a large amount of heat can be selected.

Pad electrodes 14 are formed on the main surface 11a of the semiconductor IC main body 11. A stud bump 15 as one kind of a conductive projection is formed on each of the pad electrodes 14. In the present invention, it is not essential to form a conductive projection such as the stud pump 15 on the pad electrode 14. However, when the conductive projection is provided, after the semiconductor IC is embedded, the semiconductor IC can be connected to a wiring by forming via holes by emitting a laser beam or by polishing. As described later, the semiconductor IC 10 can be positioned in the manufacture of a module with embedded semiconductor IC.

The conductive projection is not limited to the stud bump 15, and various kinds of bumps such as a plate bump, a plated bump, and a ball bump can be used. When a stud bump is used as a conductive projection, silver or copper can be wire bonded to form this stud bump. When a plate bump is used, this can be formed by plating, sputtering, or by deposition. When a plated bump is used, this can be formed by plating. When a ball bump is used, a solder ball is mounted on a land electrode, and is fused to from the ball bump, or a cream solder is printed on a land electrode, and is fused to from the ball bump.

A kind of metal that can be used for the conductive projection is not particularly limited. For example, gold (Au), silver (Ag), copper (Cu), nickel (Ni), tin (Sn), chrome (Cr), nickel chrome alloy (Ni-Cr), and solder can be used. Alternatively, a conductive material is screen printed, and is cured to form a conical or cylindrical bump. Nanopaste can be printed, heated, and sintered to form a bump.

In the present embodiment, the semiconductor IC main body 11 has a thickness ***t*** (a distance from the main surface 11a to the back surface 11b) smaller than that of a normal semiconductor IC. The thickness ***t*** of the semiconductor IC main body 11 is not particularly limited. Preferably, the thickness ***t*** is equal to or smaller than 100 micrometers, for example, about 20 to 50 micrometers. This is because when the thickness ***t*** of the semiconductor IC main body is smaller, the total thickness of the module with embedded semiconductor IC can be decreased.

When this thickness ***t*** is too small, cracks appear in the semiconductor IC main body 11, and handling becomes considerably difficult. On the other hand, when the thickness ***t*** of the semiconductor IC main body 11 is set to about 20 to 50 micrometers, occurrence of cracks and remarkable reduction in the easiness of handling can be prevented, while sufficiently decreasing the total thickness of the module with embedded semiconductor IC.

The semiconductor IC 10 according to the present embodiment has the metal layer 13. Therefore, occurrence of cracks can be prevented more effectively, and easiness of handling is more improved.

The under-barrier metal layer 12 works to increase close adhesion between the semiconductor IC main body 11 and the metal layer 13. The urider-barrier metal layer 12 is selectively provided on substantially the whole back surface 11b of the semiconductor IC main body 11, excluding the periphery 11c of the back surface 11b. In the present embodiment, the metal layer 13 is formed by electrolytic plating, as described later. Therefore, the under-barrier metal layer 12 also works as a power supply film.

A material of the under-barrier metal layer 12 is not particularly limited so long as the material meets the above objects. For example, a material that can be used includes titanium (Ti), chrome (Cr), nickel (Ni), nickel chrome alloy (Ni-Cr), and a laminate of these metals, such as nickel/chrome (Ni/Cr). Furthermore, preferably, the above material is used as a ground material, and copper (Cu) is laminated on this surface, thereby forming the under-barrier metal layer 12.

A film thickness of the under-barrier metal layer 12 is not particularly limited, and is preferably about 0.05 to 2 micrometers. As an example, when a laminate film (Cr/Cu) of chrome (Cr) and copper (Cu) is used, a thickness of the chrome (Cr) is set to about 0.5 micrometer, and a thickness of the copper (Cu) laminated on this surface is set to about 0.5 micrometer. As described later, the under-barrier metal layer 12 can be formed by sputtering or depositing. The copper (Cu) can be formed on the surface of the ground material by electroless plating.

The metal layer 13 is formed on the under-barrier metal layer 12 by electroless plating, and is selectively provided on substantially the whole back surface 11b of the semiconductor IC main body 11, excluding the periphery 11c of the back surface 11b. The metal layer 13 works as a heat dissipation route of heat generated by the operation of the semiconductor IC main body 11. At the same time, the metal layer 13 works to effectively prevent the occurrence of cracks on the back surface 11b of the semiconductor IC main body 11, and to improve easiness of handling.

A material of the metal layer 13 is not particularly limited, so long as the material is a metal that can be formed by plating. For example, the material that can be used includes copper (Cu), silver (Ag), gold (Au), titanium (Ti), chrome (Cr), nickel (Ni), nickel chrome alloy (Ni-Cr), solder, and tin (Sn). Among others, considering cost and thermal conductivity, it is very preferable to use copper (Cu). When copper (Cu) is selected as a material of the metal layer 13, copper sulfate liquid or the like can be used for plating liquid.

While a film thickness of the metal layer 13 is not particularly limited, the thickness is preferably about 1 to 50 micrometers, and more preferably about 2 to 20 micrometers. Particularly, the thickness of about 5 to 15 micrometers is preferable. This is because when the film thickness of the metal layer 13 is less than one micrometer, effect of crack prevention and effect of improving handling easiness cannot be obtained sufficiently. Furthermore, there is a risk of addition of damage to the semiconductor IC main body, at the time of exposing a part of the metal layer 13 by laser irradiation, after the semiconductor IC 10 is embedded in a multilayer substrate.

Meanwhile, when a film thickness of the metal layer 13 exceeds 50 micrometers, a thickness of the module with embedded semiconductor IC manufactured last becomes larger than is necessary. Accordingly, the effect of thinning the semiconductor IC main body 11 is halved.

On the other hand, when a film thickness of the metal layer 13 is set to within the above range, the above effect can be sufficiently obtained while decreasing the thickness of the module with embedded semiconductor IC. Furthermore, it becomes possible to decrease the risk of addition of damage to the semiconductor IC main body 11, at the time of exposing at least a part of the metal layer 13 by laser irradiation, after the semiconductor IC 10 is embedded in a multilayer substrate.

The configuration of the semiconductor IC 10 according to the present embodiment is as explained above. A method of manufacturing the semiconductor IC 10 according to the present embodiment is explained below.

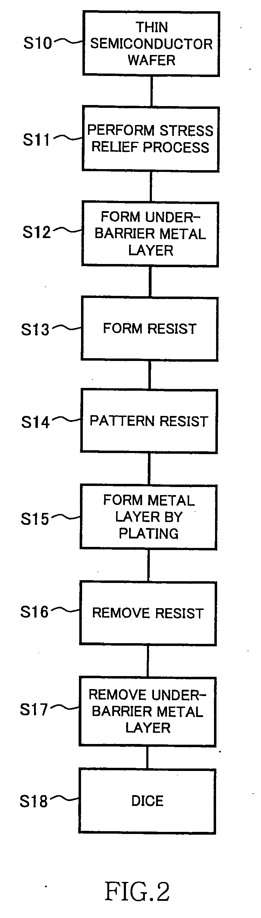

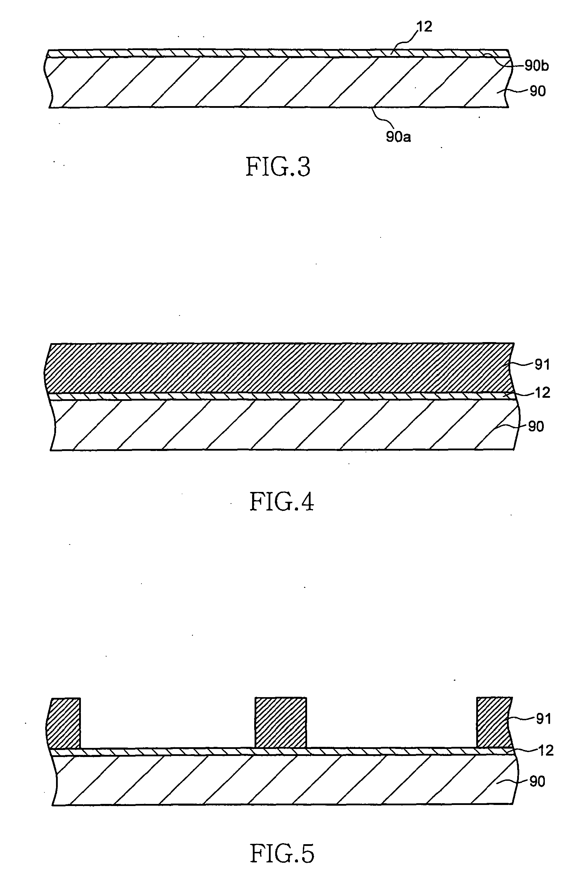

FIG. 2 is a flowchart showing a method of manufacturing the semiconductor IC 10, and FIG. 3 to FIG. 10 are process diagrams along the flowchart shown in FIG. 2.

First, as shown in FIG. 3, a back surface 90b of a semiconductor wafer 90 of which front-end process has been completed is polished, that is, a surface opposite to a main surface 90a on which a predetermined circuit such as a transistor is formed is polished, thereby thinning the semiconductor wafer 90 (step S10). However, a method of thinning the semiconductor wafer 90 is not limited to polishing, and other thinning method, such as etching, plasma treatment, laser irradiation, and blasting can be also used.

Next, a stress-relief processing is performed to the polished back surface 90b of the semiconductor wafer 90, thereby relaxing physical stress of the back surface 90b generated by the polishing (step S11). The stress relief processing includes wet etching using an etching liquid, polishing using slurry, dry polishing using a non-diamond abrasive coating, and dry etching using etching gas.

Next, the under-barrier metal layer 12 is formed on the whole back surface 90b of the semiconductor wafer 90 that has been stress-relief processed (step S12). As a method of forming the under-barrier metal layer 12, use of sputtering and deposition is preferable.

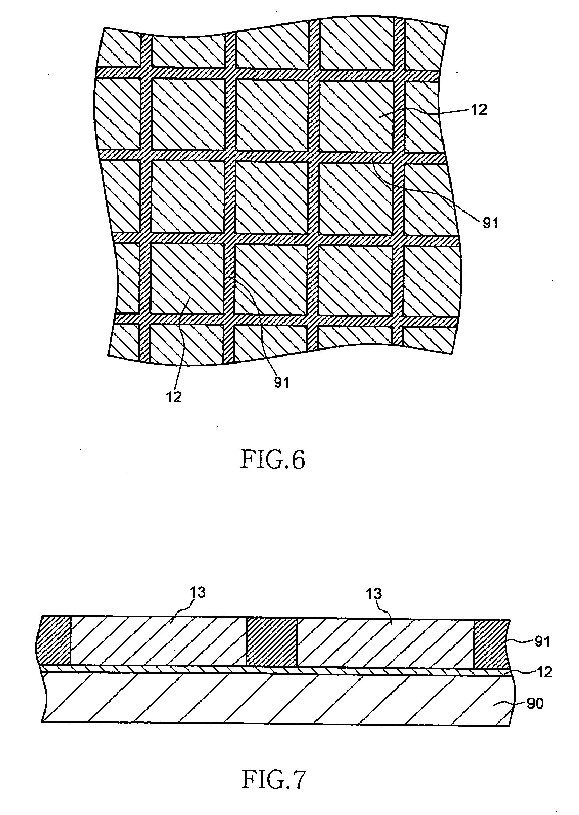

As shown in FIG. 4, a resist 91 is formed on the whole surface of the under-barrier metal layer 12 (step S13). Next, as shown in FIG. 5, the resist 91 is patterned by exposing (step S14). Accordingly, a part of the under-barrier metal layer 12 is covered with the resist 91, and the remaining part of this layer is exposed. The part of the under-barrier metal layer 12 covered with the resist 91 is a region to be disconnected by dicing, and its vicinity. Therefore, the patterned resist 91 forms a grating that separates each semiconductor IC, as shown in a partial top plan view in FIG. 6.

Next, as shown in FIG. 7, the metal layer 13 is formed on the under-barrier metal layer 12, by electrolytic plating, using the exposed under-barrier metal layer 12 as a power supply film (step S15). Accordingly, the metal layer 13 is selectively formed on the under-barrier metal layer 12.

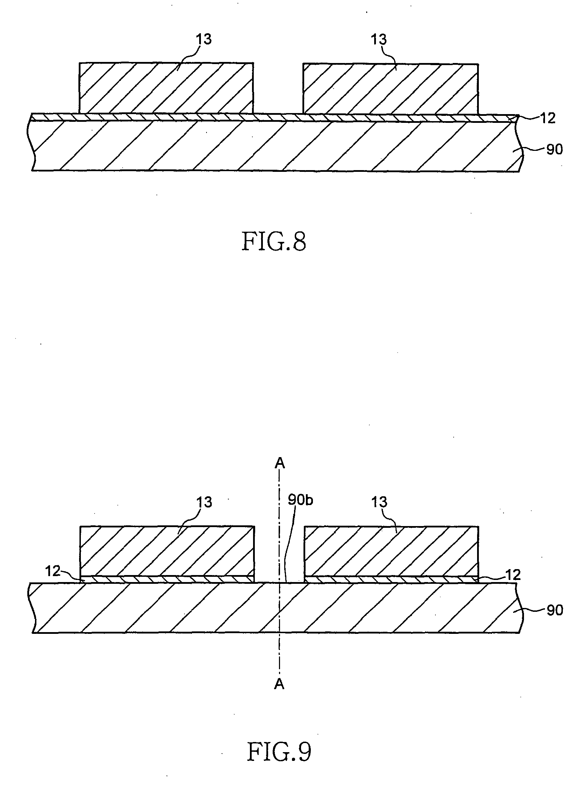

As shown in FIG. 8, the resist 91 is removed (step S16), and an unnecessary part of the under-barrier metal layer 12 on which the metal layer 13 is not formed is removed by soft etching, as shown in FIG. 9 (step S17) . Accordingly, the back surface 90b of the semiconductor wafer 90 is covered with the under-barrier metal layer 12 and the metal layer 13 at the part corresponding to each semiconductor IC, and is exposed in the dicing region and its vicinity.

The semiconductor wafer 90 is then diced along a line A-A, that is, along the exposed region not covered with the under-barrier metal layer 12 and the metal layer 13, thereby taking out individual semiconductor ICs 10 (step S18). Because the under-barrier metal layer 12 and the metal layer 13 are not formed but the semiconductor wafer 90 is exposed in the region to be diced, a normal dicer that is optimized to disconnect the semiconductor wafer can be used.

The stud bumps 15 can be formed at any stage, for example, before thinning the semiconductor wafer 90 (step S10). In order to increase adhesion with a resin, preferably, a surface of the metal layer 13 is roughened, after the metal layer 13 is formed. A roughening method includes intergranular corrosion using hydrogen peroxide/sulfuric acid or formic acid, and tanning. Furthermore, instead of roughening the surface of the metal layer 13, the surface of the metal layer 13 can be rough plated, thereby roughening the surface.

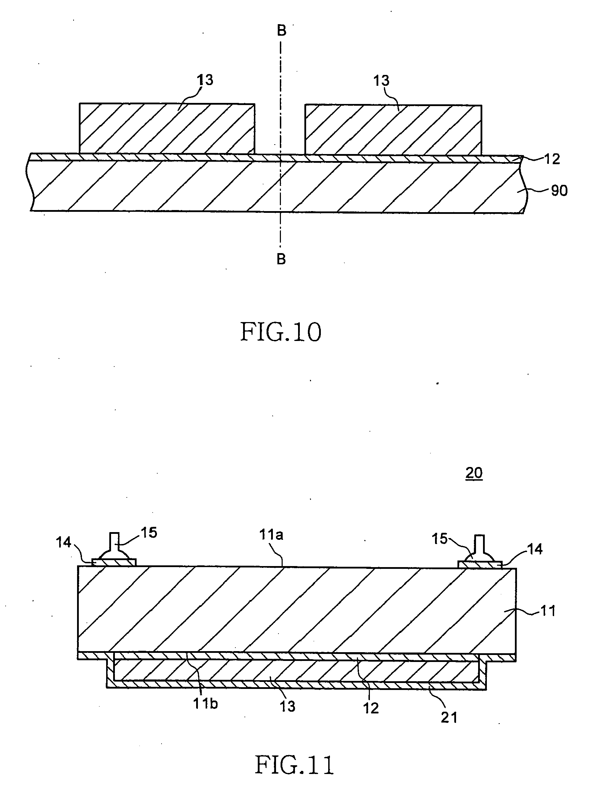

The semiconductor IC 10 shown in FIG. 1 is then completed in the method as described above. Removing the under-barrier metal layer 12 at step S17 is not essential. That is, dicing can be performed along a line B-B, while leaving the unnecessary part of the under-barrier metal layer 12 on which the metal layer 13 is not formed, as shown in FIG. 10 (step S18). With this arrangement, the soft etching process (step S17) can be omitted.

In this case, the thin under-barrier metal layer 12 is still present in the area to be diced. Therefore, the dicing condition needs to be different from a normal condition in some cases, to avoid the occurrence of chipping. However, because the under-barrier metal layer 12 has a very small film thickness, the dicing condition of avoiding the chipping is not so strict.

According to the above method, the metal layer 13 is selectively formed. Therefore, it is possible to avoid warpage that occurs when a thick metal layer is formed on the whole surface of the thinned semiconductor wafer 90. The region in which the metal layer 13 is not formed corresponds to a region to be diced. Therefore, the laminate of the semiconductor wafer and the thick metal does not need to be diced. As a result, chipping of the disconnected surface can be effectively prevented.

The above explains the method of manufacturing the semiconductor IC 10. A semiconductor IC according to other embodiment of the present invention is explained next.

FIG. 11 is a schematic cross-sectional view of a configuration of a semiconductor IC 20 according to another preferred embodiment of the present invention.

The semiconductor IC 20 according to the present embodiment is the same as the semiconductor IC 10 according to the above embodiment, except that the semiconductor IC 20 includes a rust preventing film 21 that covers the back surface. Therefore, identical constituent elements are assigned with like reference numerals, and their redundant explanation is omitted.

The rust preventing film 21 covers the back surface of the semiconductor IC 20, that is, the bottom surface and the side surface of the semiconductor IC 20 on which the metal layer 13 and the under-barrier metal layer 12 are exposed, and also covers the back surface 11b of the semiconductor IC main body 11 that is exposed at the periphery 11c.

With this arrangement, the rust preventing film 21 works to prevent corrosion of the metal layer 13 and to increase close adhesion between the resin and the semiconductor IC 20. A materia-1 of the rust preventing film 21 is not particularly limited so long as the material meets the above objects. For example, the material used includes titanium (Ti), chrome (Cr), nickel (Ni), nickel-chrome alloy (Ni-Cr), and a laminate of these metals, such as nickel/chrome (Ni/Cr).

A film thickness of the rust preventing film 21 is not particularly limited, and is preferably about 0.005 to 0.5 micrometer. As an example, when chrome (Cr) is used, the film thickness is set to about 0. 05 micrometer.

As explained above, because the semiconductor IC 20 according to the present embodiment has the rust preventing film 21 that covers the metal layer 13, oxidation and corrosion of the metal layer 13 can be effectively prevented, even when a corrosive material such as copper (Cu) is selected for the material of the metal layer 13. As a result, high reliability can be obtained.

As a method of manufacturing the semiconductor IC 20, a process of forming the rust preventing film 21 by sputtering is added to between the process of removing the under-barrier metal layer (step S17) and the process of dicing (step S18). In this case, the dicing is performed in the state that the thin rust preventing film 21 is present in the region to be diced, as explained with reference to FIG. 10. Therefore, the dicing needs to be performed in the condition of not generating chipping. However, since the rust preventing film 21 has a very small thickness like the under-barrier metal layer 12, the dicing condition that avoids chipping is not so strict.

In this case, preferably, the surface of the metal layer 13 is roughened after the metal layer 13 is formed and before the rust preventing film 21 is formed. As described above, because the rust preventing film 21 has a very small thickness, the roughened surface of the metal layer 13 is reflected to the rust preventing film 21. As a result, close adhesion between the metal layer 13 and the resin can be further improved.

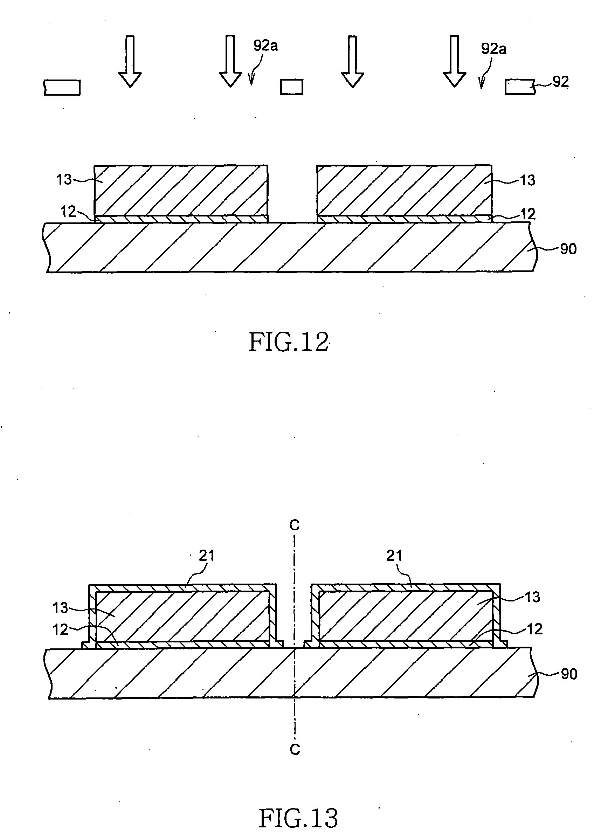

In order to securely prevent chipping in the dicing process (step S18), preferably, the rust preventing film 21 is selectively formed in the region of the semiconductor IC main body 11, excluding the periphery 11c. In order to perform this selective formation, a metal mask 92 for covering the region to be disconnected by dicing and its vicinity is used, and selective sputtering or deposition can be performed via an opening 92a of the metal mask 92, as shown in FIG. 12.

As a result, as shown in FIG. 13, the rust preventing film 21 is formed on substantially the whole surface excluding at least a part not covered by the metal layer 13. Therefore, when the semiconductor wafer 90 is diced along a line C-C as shown in FIG. 13, individual semiconductor ICs 20 can be easily obtained, without generating chipping.

A module with embedded semiconductor IC that has the semiconductor IC 10 embedded in a module is explained next.

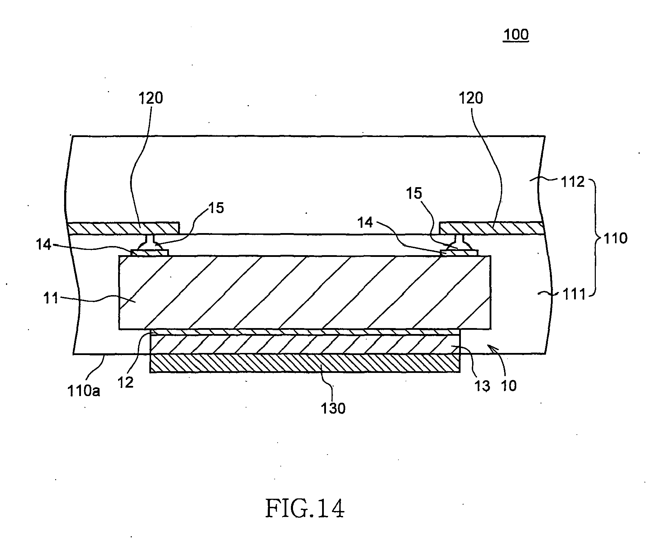

FIG. 14 a schematic cross-sectional view of a configuration of a module with embedded semiconductor IC 100 according to a preferred embodiment of the present invention.

As shown in FIG. 14, the module with embedded semiconductor IC 100 according to the present embodiment includes: a multilayer substrate 110 consisting of laminated resin layers 111 and 112; the semiconductor IC 10 embedded in the multilayer substrate 110; an internal conductive pattern 120 formed within the multilayer substrate 110; and a heat dissipation electrode 130 provided on a bottom surface 110a of the multilayer substrate 110.

The module with embedded semiconductor IC 100 according to the present embodiment also includes a signal terminal electrode and a power source terminal electrode connected to the internal conductive pattern 120. However, these electrodes are not directly relevant to the gist of the present invention, and are, therefore, not shown in FIG. 14. While the semiconductor IC 10 shown in FIG. 1 is embedded in the module with embedded semiconductor IC 100 according to the present embodiment, the semiconductor IC 20 shown in FIG. 11 can be also embedded, in place of the semiconductor IC 10.

In actually use of the module with embedded semiconductor IC 100, the module with embedded semiconductor IC 100 is mounted on a motherboard so that the mounting surface of the motherboard (not shown) faces the bottom surface 110a of the multilayer substrate 110. A ground pattern provided on the mounting surface of the motherboard and a heat dissipation electrode 130 provided on the module with embedded semiconductor IC 100 are electrically and mechanically connected to each other.

A material of the resin layers 111 and 112 can be a thermosetting resin or a thermoplastic resin having reflow durability. Specifically, any material can be selected from among an epoxy resin, bismalaimide-triazine resin (BT resin), a phenol resin, a vinyl benzene resin, a polyphenylene ether (polyphenylene etheroxide) resin (PPE, PPO), a cyanate resin, a benzooxyazine resin, a polyimide resin, aromatic polyester resin, polyphenylene sulfide resin, a polyetherimide resin, a polyarilate resin, and a polyetheretherketone resin. A material of unwoven cloth such as glass cloth, aramid, aromatic polyester that is impregnated with one of the above resins can be also used. A material of the above resin that is impregnated with a filler can be also used.

As explained above, the module with embedded semiconductor IC 100 according to the present embodiment incorporates the thinned semiconductor IC 10. Therefore, the total module with embedded semiconductor IC 100 can be thinned. The metal layer 13 provided on the semiconductor IC 10 is exposed on the bottom surface 110a of the multilayer substrate 110, and the heat dissipation electrode 130 is directly formed on the exposed metal layer 13.

Therefore, heat generated by the operation of the semiconductor IC 10 can be dissipated to the motherboard remarkably efficiently. Consequently, a digital IC having a very high operation frequency such as a CPU and a DSP can be selected for the semiconductor IC 10.

A method of manufacturing the module with embedded semiconductor IC 100 is explained next.

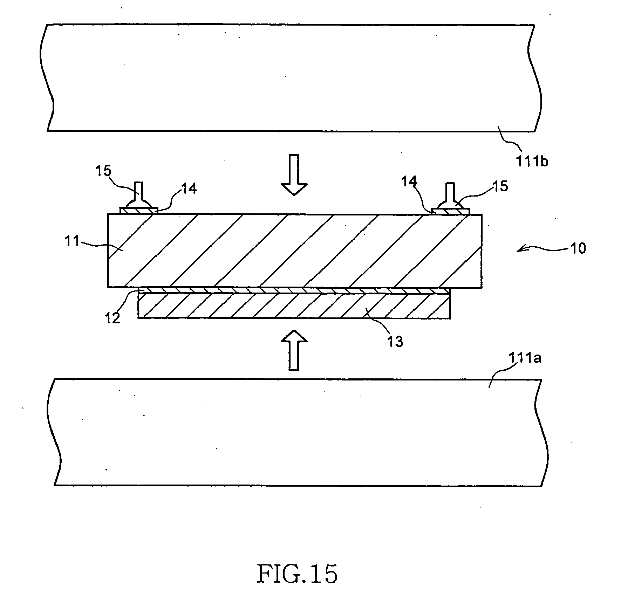

FIG. 15 to FIG. 19 are process diagrams sequentially depicting a method of manufacturing the module with embedded semiconductor IC 100.

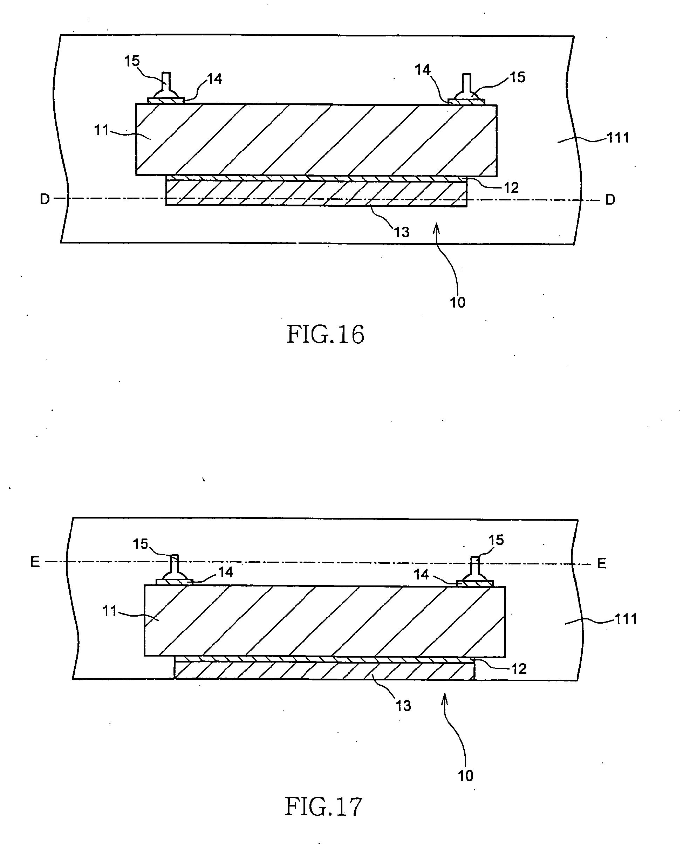

First, as shown in FIG. 15, two prepregs 111a and 111b are prepared, and the semiconductor IC 10 is pressed by the two prepregs 111a and 111b. The prepreg is a sheet of fiber such as glass fiber and aramid fiber that is impregnated with an uncured thermosetting resin such as an epoxy resin. When the semiconductor IC 10 is heated while being pressed by the prepregs 111a and 111b, the thermosetting resin contained in the prepregs 111a and 111b is cured, and the resin layer 111 is formed as shown in FIG. 16. The semiconductor IC 10 is embedded in the resin layer 111.

Next, the bottom surface of the resin layer 111 embedded with the semiconductor IC 10 is polished, thereby removing a part of the resin layer 111 up to a line D-D shown in FIG. 16. As a result, the metal layer 13 of the semiconductor IC 10 is exposed, and the bottom surface of the resin layer 111 forms substantially the same plane as the front surface of the metal layer 13.

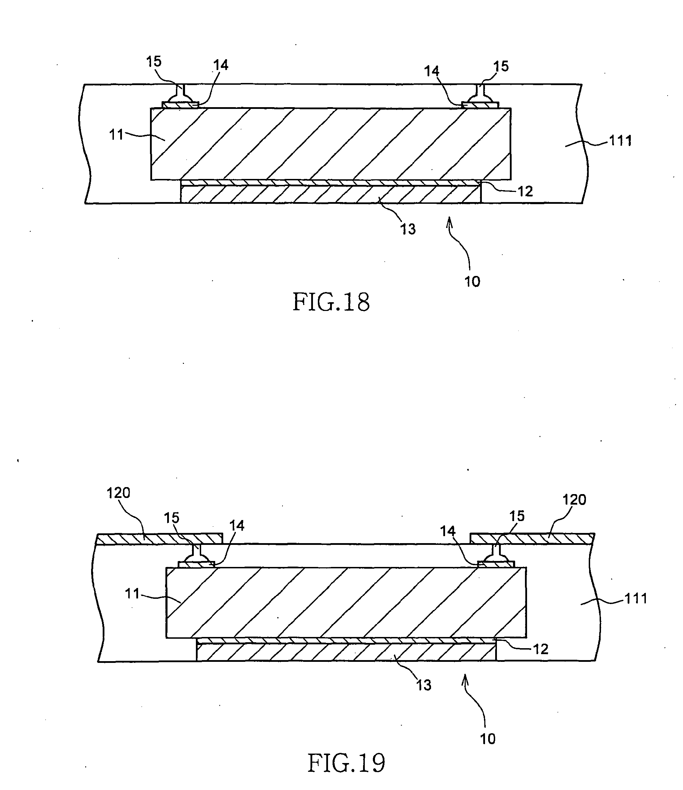

The upper surface of the resin layer 111 is then polished, thereby removing a part of the resin layer 111 up to a line E-E shown in FIG. 17, and exposing a part of the stud bumps 15 of the semiconductor IC 10 as show in FIG. 18.

As shown in FIG. 19, the internal conductive layer 120 is formed to be connected to the exposed stud bump 15, and the resin layer 112 that covers the internal conductive layer 120 is formed. Furthermore, the heat dissipation electrode 130 is formed, thereby completing the module with embedded semiconductor IC 100 shown in FIG. 14.

When the module with embedded semiconductor IC 100 is manufactured in the above method, substantially the whole surface of the metal layer 13 can be exposed. Therefore, a configuration having remarkably high heat dissipation can be obtained. In this case, when the metal layer 13 has a smaller thickness, high precision is required to adjust the amount of polishing the resin layer 111. When the metal layer 13 has a certain level of thickness (preferably equal to or larger than 5 micrometers), higher precision is not required to adjust the amount of polishing, and polishing can be performed easily.

According to the above manufacturing method, the metal layer 13 of the semiconductor IC 10 is exposed by polishing the bottom surface of the resin layer 111. The method of exposing the metal layer 13 is not limited to this.

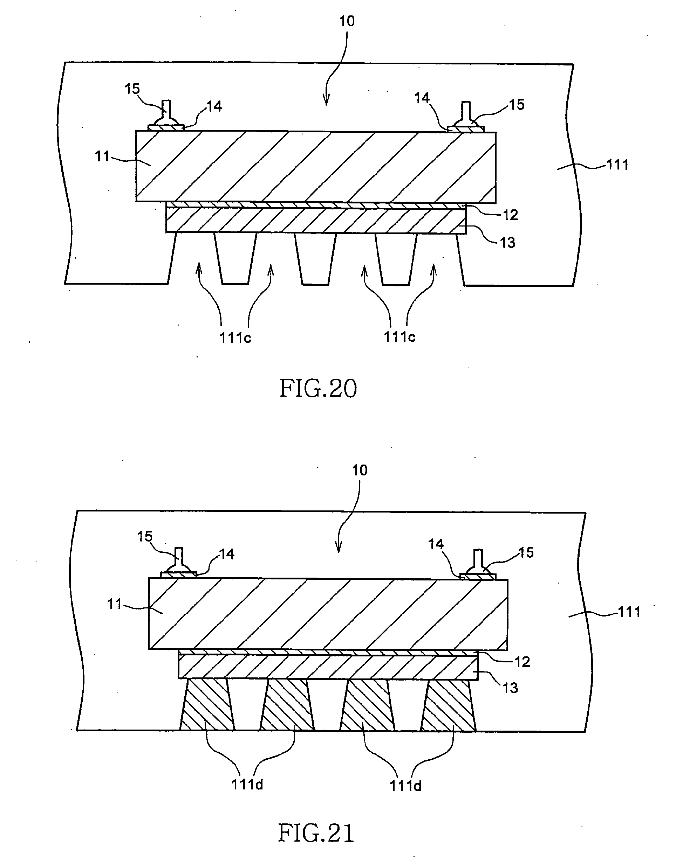

As shown in FIG. 20, via holes 111c can be formed in the resin layer 111, by irradiating a laser beam, thereby exposing a part of the metal layer 13. In this case, as shown in FIG. 21, a material 111d having higher thermal conductivity than that of the resin layer 111 is embedded in the via holes 111c, and the heat dissipation electrode 130 is formed on the surface of the embedded material 111d. When the thickness of the metal layer 13 is too small, there is a risk that the semiconductor wafer 90 is directly damaged by energy of the irradiated laser beam, and the circuit such as the transistor formed on the semiconductor IC 10 is damaged. However, when the metal layer 13 has a certain level of thickness (preferably equal to or larger than 5 micrometers), occurrence of this damage can be prevented.

Either one of or both a metal and a conductive adhesive can be used for the embedded material 111d. When metal is used for the embedded material 111d, this can be formed by plating. Preferably, the embedded material 111d is completely filled. Plating and a conductive or insulating paste can be used together, or a conductive adhesive can be used.

In this case, the embedded material 111d can be formed by screen printing. When plating and a conductive or insulating paste are used together, the sidewall of the via holes 111c is covered with metal, and the inside is filled with the conductive or insulating paste. When the conductive or insulating paste is used, the paste preferably contains a filler to increase thermal conductivity.

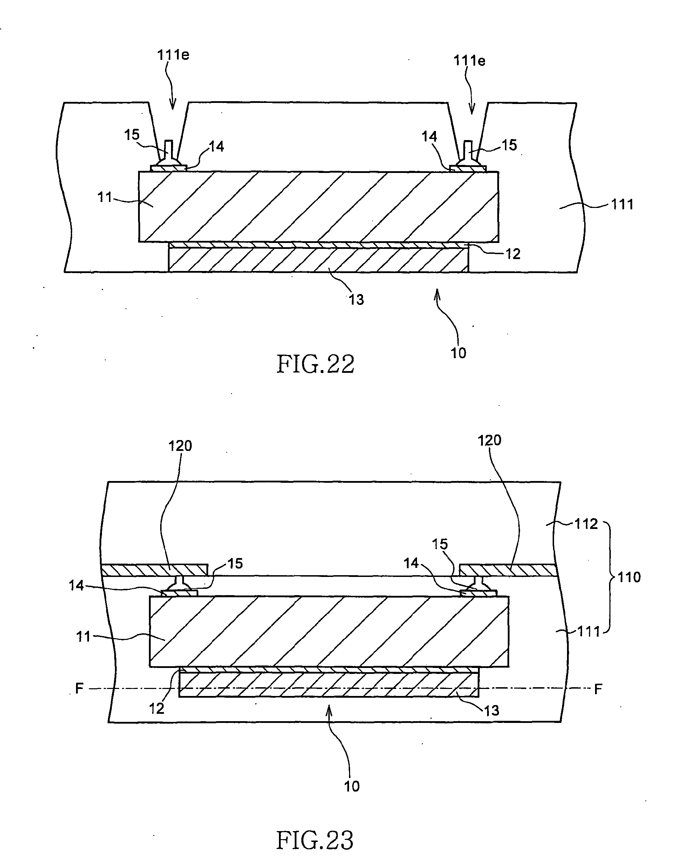

Furthermore, according to the above manufacturing method, the stud bumps 15 of the semiconductor IC 10 are exposed by polishing the upper surface of the resin layer 111. Alternatively, as shown in FIG. 22, via holes 111e can be formed in the resin layer 111 by irradiating a laser beam, thereby exposing a part of a conductive projection such as the stud bumps 15.

Furthermore, according to the above manufacturing method, the bottom surface of the resin layer 111 is polished to expose the metal layer 13 of the semiconductor IC 10. Thereafter, the internal conductive pattern 120 is formed, and the resin layer 112 is formed to cover the internal conductive pattern 120. Alternatively, as shown in FIG. 23, after the internal conductive pattern 120 and the resin layer 112 are formed, a part of the semiconductor IC 100 up to a line F-F can be removed by polishing.

When the pitch of the pad electrodes 14 provided on the semiconductor IC 10 is very small, for example, when the pitch is equal to or smaller than 100 micrometers, particularly about 60 micrometers, high precision is required in the positioning of the pad electrodes 14 and the internal conductive pattern 120. In this case, it is effective to perform positioning using conductive projections such as the stud bumps 15 provided on the pad electrodes 14.

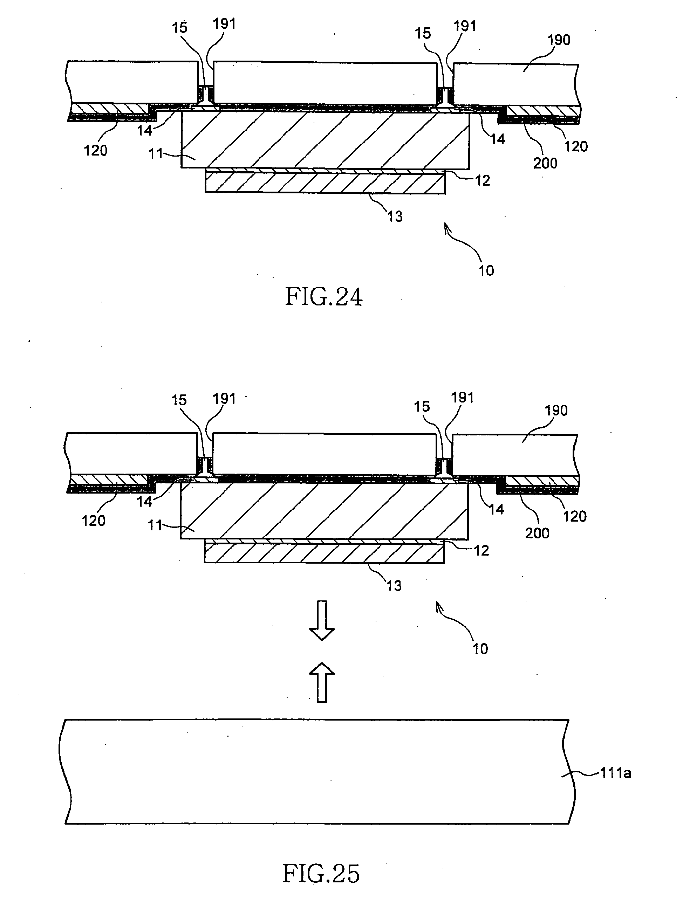

For example, as shown in FIG. 24, a transfer plate 190 formed with positioning holes 191 and an internal conductive pattern 120 is prepared in advance. An adhesive sheet 200 is laminated on this. The stud bumps 15 of the semiconductor IC 10 are engaged with the positioning holes 191, and are provisionally stopped. In this state, as shown in FIG. 25, the prepreg 111a and the transfer substrate 190 are pressed, and the transfer substrate 190 is peeled off.

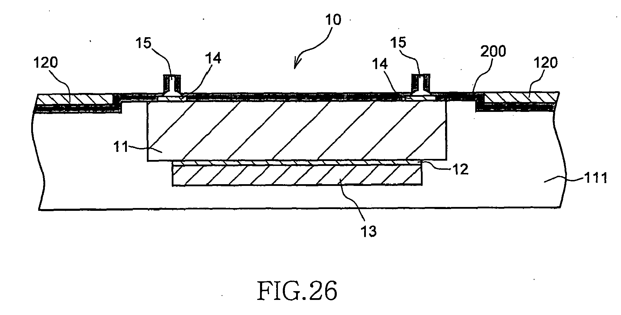

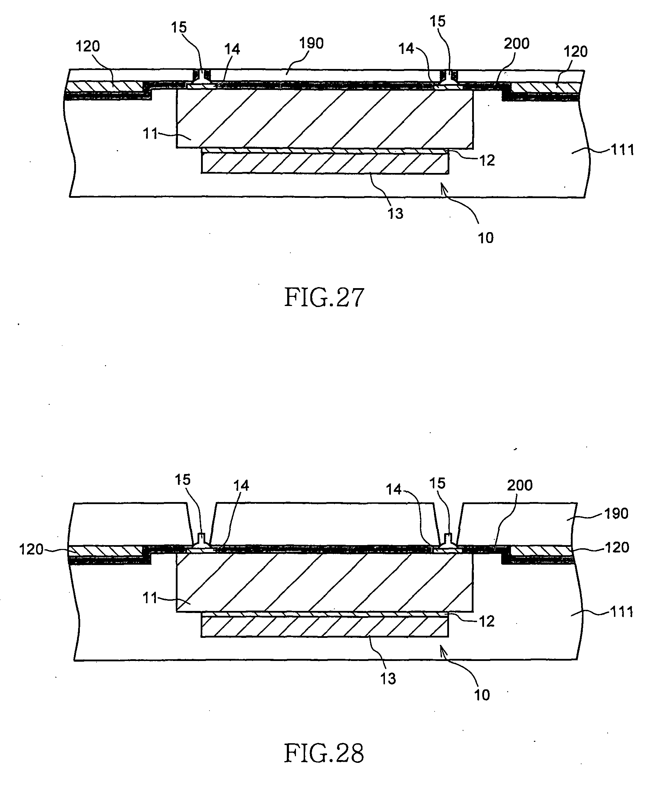

As shown in FIG. 26, the internal conductive pattern 120 and the semiconductor IC 10 are embedded in the resin layer 111. Alternatively, instead of peeling off the transfer substrate 190, the transfer substrate 190 is polished, after the internal conductive pattern 120 and the semiconductor IC 10 are embedded, thereby exposing the stud bumps 15, as shown in FIG. 27.

Alternatively, after the internal conductive pattern 120 and the semiconductor IC 10 are embedded, the transfer substrate 190 is irradiated with a laser beam to form via holes, thereby exposing the stud bumps 15, as shown in FIG. 28. In this case, a positional relationship between the internal conductive pattern 120 and the stud bumps 15 of the semiconductor IC 10 is prescribed by the transfer substrate 190. Therefore, no positional deviation occurs between the internal conductive pattern 120 and the stud bumps 15 of the semiconductor IC 10. Consequently, even when the pitch of the pad electrodes 14 provided on the semiconductor IC 10 is very small, it becomes possible to prevent the occurrence of a positional deviation between the stud bumps 15 and the internal conductive pattern 120.

Thereafter, as shown in FIG. 17, substantially the whole surface of the metal layer 13 of the semiconductor IC 10 is exposed by polishing. Alternatively, as shown in FIG. 20, the via holes 111c are formed in the resin layer 111 by irradiating a laser beam, thereby exposing a part of the metal layer 13. At the same time, other internal conductive pattern 120 and the resin layer 112 are formed, and bumps of the heat dissipation electrode 130 are formed, thereby completing the module with embedded semiconductor IC.

As explained above, the module with embedded semiconductor IC 100 according to the present embodiment incorporates the thinned semiconductor IC 10, and can dissipate, remarkably efficiently, heat generated by the operation of the semiconductor IC 10, to the motherboard. Therefore, the invention can provide a thin module embedded with a digital IC having a very high operation frequency such as a CPU and a DSP.

Because the back surface 11b of the semiconductor IC main body 11 is protected by the metal layer 13, a crack is not easily generated in the semiconductor IC main body 11, despite a heat shock during the press process and the manufacturing process, a heat shock after a completion of the product, or during a reliability test of reflow and a mechanical stress test such as a bending test. Consequently, high reliability can be obtained.

As explained above, the semiconductor IC according to the present invention can obtain high thermal conductivity, even when the semiconductor IC is embedded in a circuit board made of resin.
Therefore, the present can be very suitably applied to a semiconductor IC having high heat generation such as a CPU and a DSP. Because a metal layer is selectively provided, warpage does not occur in the wafer state, even when the semiconductor IC main body is thinned by polishing. Accordingly, the semiconductor IC can be manufactured easily.

Because the metal layer is provided at the center of the back surface of the semiconductor IC main body, a laminate of the semiconductor wafer and the thick metal does not need to be diced. As a result, chipping of the disconnected surface can be prevented effectively. Consequently, a thin module with embedded semiconductor IC having high heat dissipation can be manufactured, by embedding this semiconductor IC in a multilayer substrate.

The present invention is in no way limited to the aforementioned embodiments, but rather various modifications are possible within the scope of the invention as recited in the claims, and naturally these modifications are included within the scope of the invention.

## Claims

1. A semiconductor integrated circuit, comprising:
a main body that a predetermined circuit is formed on a main surface thereof; and
a metal layer selectively provided at a center of a back surface of the main body.

2. The semiconductor integrated circuit as claimed in claim 1, wherein said metal layer is provided on substantially the whole back surface of the main body except a periphery of the back surface.

3. The semiconductor integrated circuit as claimed in claim 1 or 2, further comprising an under-barrier metal layer provided between at least the metal layer and the back surface of the main body.

4. The semiconductor integrated circuit as claimed in any one of claims 1 to 3, further comprising a rust preventing film that covers a bottom surface and a side surface of the metal layer.

5. The semiconductor integrated circuit as claimed in claim 4, wherein said rust preventing film is selectively provided in a region of the back surface of the main body except a periphery of the back surface.

6. The semiconductor integrated circuit as claimed in any one of claims 1 to 5, wherein said main body is thinned.

7. A method of manufacturing a semiconductor integrated circuit, comprising:
a first step for selectively forming a metal layer on a back surface of a semiconductor wafer that a predetermined circuit is formed on a main surface thereof; and
a second step for disconnecting the semiconductor wafer along a region in which the metal layer is not formed.

8. The method of manufacturing a semiconductor integrated circuit as claimed in claim 7, wherein said first step includes:
a step for forming an under-barrier metal layer on substantially the whole back surface of the semiconductor wafer; and
a step for selectively forming the metal layer on the under-barrier metal layer by plating while covering a part of the under-barrier metal layer with a resist.

9. The method of manufacturing a semiconductor integrated circuit as claimed in claim 8, wherein said first step further includes:
a step for removing the resist after selectively forming the metal layer; and
a step for removing the under-barrier metal layer exposed by removing the resist.

10. The method of manufacturing a semiconductor integrated circuit as claimed in any one of claims 7 to 9, further comprising a step for thinning the semiconductor wafer before performing the first step.

11. The method of manufacturing a semiconductor integrated circuit as claimed in any one of claims 7 to 10, further comprising a step for forming a rust preventing film that covers a bottom surface and a side surface of the metal layer after performing the first step and before performing the second step.

12. The method of manufacturing a semiconductor integrated circuit as claimed in claim 11, wherein said step for forming the rust preventing film is performed by selectively forming the rust preventing film on substantially the whole back surface of the semiconductor wafer, except at least a part of a region of the back surface not covered with the metal layer.

13. The method of manufacturing a semiconductor integrated circuit as claimed in any one of claims 7 to 12, further comprising a step for roughening a surface of the metal layer.

14. A module with embedded semiconductor integrated circuit, comprising:
a semiconductor integrated circuit including a main body that a predetermined circuit is formed on a main surface thereof and a metal layer selectively provided at a center of a back surface of the main body; and
a resin layer into which the semiconductor IC is embedded.

15. A method of manufacturing a module with embedded semiconductor integrated circuit, comprising:
a first step for embedding a semiconductor integrated circuit including a main body that a predetermined circuit is formed on a main surface thereof and a metal layer selectively provided at a center of a back surface of the main body; and
a second step for exposing at least a part of a surface of the metal layer.

16. The method of manufacturing a module with embedded semiconductor integrated circuit as claimed in claim 15, wherein said second step is performed by exposing substantially a whole bottom surface of the metal layer by polishing a bottom surface of the resin layer.

17. The method of manufacturing a module with embedded semiconductor integrated circuit as claimed in claim 15, wherein said second step is performed by exposing at least a part of a bottom surface of the metal layer by forming via holes on a bottom surface of the resin layer.

18. The method of manufacturing a module with embedded semiconductor integrated circuit as claimed in claim 17, further comprising a third step for embedding the via holes with a material having higher thermal conductivity than that of the resin layer.
